# DEMANDE DE BREVET EUROPEEN

(11) **EP 4 742 245 A1**
(43) Date de publication de la demande: **13.05.2026**
(21) Numéro de dépôt: 25213775.7
(22) Date de dépôt: 05.11.2025
(51) Int. Cl.: G11C 13/00, H10B 63/10, H10N 70/20, H10B 63/00, H10N 70/00

(54) **DISPOSITIF ELECTRONIQUE COMPRENANT UN CIRCUIT MEMOIRE**

(30) Priorité: 07.11.2024 FR 2412188
(71) Demandeur: STMicroelectronics International N.V., 1228 Plan-les-Ouates, Geneva (CH)
(72) Inventeur: WEBER, Olivier, 38000 GRENOBLE (FR)
(74) Mandataire: Cabinet Beaumont

(57) **Abrégé**

La présente description concerne un dispositif mémoire (300) comportant une pluralité de cellules mémoire organisées en une matrice de lignes mots et de bits, chaque cellule comportant un élément mémoire (M) à changement de phase et deux transistors (T), connectés par leurs premiers noeuds, eux même connectés à une première borne de l'élément, où :
les éléments d'une ligne bits sont connectés par leurs deuxièmes bornes ;
les deux transistors d'une ligne de mots sont connectés par leurs grilles ;
chaque cellule est connectée à deux lignes de sources, respectivement connectées à deux deuxièmes noeuds des transistors, les cellules d'une ligne de mots étant connectées aux deux lignes de sources et les cellules de deux lignes de mots successives étant connectées à une ligne de sources commune ; et
chaque transistor est disposé dans et sur une paire de deux ailettes disposées dans un substrat semiconducteur (301).

## Description

### Domaine technique

La présente description concerne de façon générale les dispositifs électroniques et plus particulièrement les dispositifs électroniques comprenant un circuit mémoire.

### Technique antérieure

Des dispositifs électroniques comportent à la fois des circuits mémoires et des circuits logiques. On s'intéresse ici plus particulièrement à des dispositifs électroniques comprenant des circuits mémoires, dits dispositifs mémoires, incluant des éléments mémoires disposés en matrice, chaque élément mémoire étant associé à un ou plusieurs transistors de sélection. Ce transistor est utilisé pour programmer, effacer ou lire chaque élément mémoire indépendamment.

Il serait souhaitable d'améliorer au moins en partie certains aspects des dispositifs électroniques connus.

### Résumé de l'invention

Pour cela, un mode de réalisation prévoit un dispositif mémoire comportant une pluralité de cellules mémoire organisées en une matrice de lignes mots et lignes de bits, chaque cellule mémoire comportant un élément mémoire en un matériau à changement de phase et deux transistors à effet de champ à ailettes de sélection de l'élément mémoire, chaque transistor comprenant des premier et deuxième noeuds de conduction et une grille, l'élément mémoire comportant deux bornes, dans lequel :
- les deux transistors d'une même cellule mémoire sont connectés entre eux par leurs premiers noeuds de conduction, lesdits premier noeuds de conduction étant eux même connectés à une première borne de l'élément mémoire ;
- les éléments mémoires d'une même ligne bits sont tous connectés entre eux par leurs deuxièmes bornes ;
- les deux transistors des cellules mémoire d'une même ligne de mots sont tous connectés entre eux, par leurs grilles ;
- chaque cellule mémoire est connectée à deux lignes de sources, les deux lignes de sources étant connectées respectivement aux deux deuxièmes noeuds de conduction des transistors de la cellule mémoire, les cellules mémoire d'une même ligne de mots étant connectées aux mêmes deux lignes de sources et les cellules mémoire de deux lignes de mots successives étant connectées à une ligne de sources commune ; et
- chaque transistor est disposé dans et sur une paire de deux ailettes parallèles et voisines disposées dans un substrat semiconducteur.

Selon un mode de réalisation, les transistors des cellules mémoire d'une même ligne de bits sont disposés dans et sur la même paire de deux ailettes.

Selon un mode de réalisation, les ailettes d'une même paire sont espacées de 20 nm à 25 nm, par exemple d'environ 22 nm.

Selon un mode de réalisation, les paires d'ailettes, sur et dans lesquelles sont disposées les cellules mémoire de deux lignes de bits successives, sont espacées de 60 nm à 65 nm, par exemple d'environ 62 nm.

Selon un mode de réalisation, le matériau à changement de phase est un alliage de germanium, antimoine et tellure.

Selon un mode de réalisation, au sein de chaque cellule mémoire, l'élément mémoire est séparé des transistors par un empilement d'interconnexion.

Selon un mode de réalisation, chaque élément mémoire est connecté aux premiers noeuds de conduction des deux transistors de la même cellule mémoire par l'intermédiaire d'un via conducteur traversant l'empilement d'interconnexion.

Selon un mode de réalisation, l'élément mémoire comporte un élément résistif métallique chauffant disposé sous le matériau à changement de phase et contrôlant ce même matériau.

Selon un mode de réalisation, les lignes de sources sont, en vue de dessus, parallèles aux lignes de mots.

Selon un mode de réalisation, les ailettes sont disposées dans une première région du substrat semiconducteur, le dispositif comprenant en outre, d'autres ailettes, espacées régulièrement, disposées dans une deuxième région du substrat semiconducteur.

Un autre mode de réalisation prévoit un procédé de fabrication d'un dispositif comportant une pluralité de cellules mémoire organisées en une matrice de lignes mots et lignes de bits, chaque cellules mémoire comportant un élément mémoire en un matériau à changement de phase et deux transistors à effet de champ à ailettes de sélection de l'élément mémoire, chaque transistor comprenant des premier et deuxième(S) noeuds de conduction et une grille, l'élément mémoire comportant deux bornes, dans lequel :
- les deux transistors d'une même cellule mémoire sont connectés entre eux par leurs premiers noeuds de conduction, lesdits premiers noeuds de conduction étant eux même connectés à une première borne de l'élément mémoire ;
- les éléments mémoires d'une même ligne bits sont tous connectés entre eux par leurs deuxièmes bornes ;
- les deux transistors des cellules mémoire d'une même ligne de mots sont tous connectés entre eux, par leurs grilles ;
- chaque cellule mémoire est connectée à deux lignes de sources, les lignes de sources étant connectées respectivement aux deux deuxièmes noeuds de conduction des transistors de la cellule mémoire, les cellules mémoire d'une même ligne de mots étant connectées aux mêmes deux lignes de sources et les cellules mémoire de deux lignes de mots successives étant connectées à une ligne de sources commune, le procédé comportant les étapes de :
- formation d'ailettes dans un substrat semiconducteur, les ailettes étant formées par paires ;
- formation d'une couche semiconductrice par épitaxie ; et
- dopage de la couche semiconductrice de façon à former des régions parmi lesquelles des premières régions correspondent à des régions de source et des deuxième régions correspondent à des régions de drain, une région de drain étant commune aux deux transistors d'une même cellule mémoire et une région de source étant commune à deux transistors de deux cellules mémoire voisines.

Selon un mode de réalisation, la formation des ailettes est réalisée dans une première région du substrat semiconducteur,
le procédé comprenant en outre, pendant l'étape de formation des ailettes, la formation d'autres ailettes, espacées régulièrement, dans une deuxième région du substrat semiconducteur.

Selon un mode de réalisation, le procédé comprend pour la sélection d'une cellule mémoire d'une première ligne de mots et d'une première ligne de bits :
- application d'un premier potentiel non nul sur la première ligne de bits et d'un potentiel nul sur les autres lignes de bits ;
- application d'un deuxième potentiel non nul sur la première ligne de mots et d'un potentiel nul sur les autres lignes de mots ;
- application d'un potentiel nul aux deux lignes de sources connectées aux cellules mémoire de la première ligne de mots et un troisième potentiel non nul aux autres lignes de sources.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 est un exemple d'un circuit électronique d'un dispositif mémoire comportant plusieurs cellules mémoire de type mémoire à changement de phase ;
la figure 2 est un exemple d'un circuit électronique d'un dispositif mémoire comportant plusieurs cellules mémoire de type mémoire à changement de phase selon un mode de réalisation ;
la figure 3A, la figure 3B, la figure 3C, la figure 3D et la figure 3E sont des vues, partielles et schématiques, d'un exemple du dispositif mémoire de la figure 2 ;
la figure 4A et la figure 4B sont des vues, partielles et schématiques, d'un autre exemple du dispositif mémoire de la figure 2 ; et
la figure 5A, la figure 5B, la figure 5C et la figure 5D sont des vues, partielles et schématique, illustrant des étapes d'un exemple de procédé de fabrication du dispositif mémoire illustré en figures 3A à 3E et en figures 4A et 4B.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % ou à 10° près, de préférence à 5 % ou à 5° près.

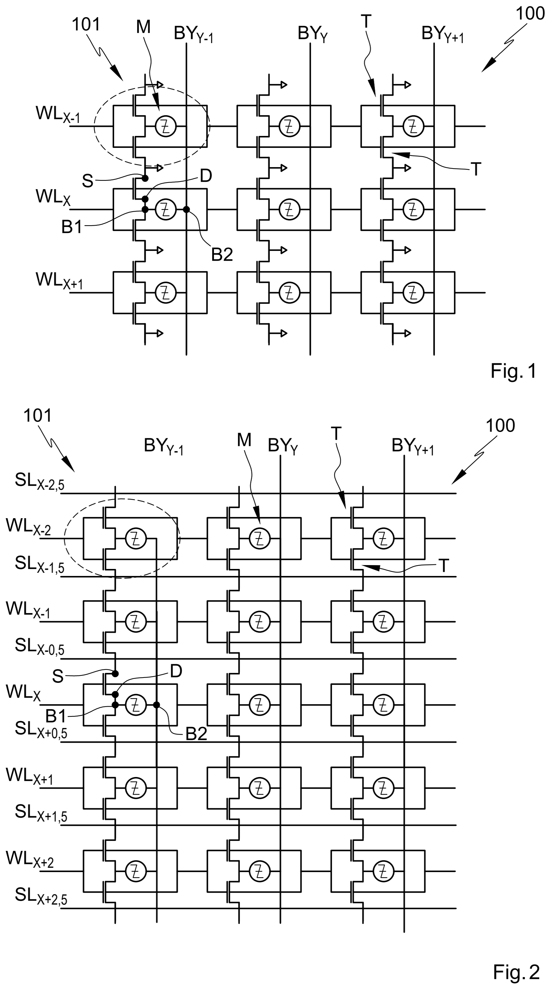

La figure 1 est un exemple d'un circuit électronique d'un dispositif mémoire 100 comportant plusieurs cellules mémoire 101 de type mémoire à changement de phase.

Le dispositif 100 est par exemple une puce électronique.

Le dispositif mémoire 100 comporte par exemple plusieurs cellules 101 rangées en une matrice comportant des lignes et des colonnes. Dans l'exemple de la figure 1, les lignes du dispositif 100 sont appelées lignes de mots WL (« word lines » en anglais) et les colonnes du dispositif 100 sont appelées lignes de bits BL (« bit lines » en anglais). A titre d'exemple, une cellule mémoire est ainsi formée à l'intersection d'une ligne de bits et d'une ligne de mots.

A titre d'exemple, le dispositif 100 comporte un nombre de lignes de mots supérieur à 3, par exemple supérieur à 100, par exemple de l'ordre de 512. En figure 1, seulement trois lignes de mots sont représentées et référencées WLₓ₋₁, WLₓ et WL_{X+1}.

A titre d'exemple, le dispositif 100 comporte un nombre de lignes de bits supérieur à 3, par exemple supérieur à 500, par exemple de l'ordre de 2432. En figure 1, seulement trois lignes de bits sont représentées et référencées BL_{y-1}, BL_{y} et BL_{y+1}.

Chaque cellule mémoire 101 comporte un élément mémoire M, comportant une première et une deuxième borne, et deux transistors T, comportant chacun un premier nœud de conduction D, par exemple un drain, un deuxième nœud de conduction S, par exemple une source et une grille. Dans le dispositif mémoire 100, les deux transistors T de chaque cellule 101 ont leurs drains connectés. De plus, dans le dispositif mémoire 100, les deux transistors T de chaque cellule 101 ont leurs sources connectées.

Dans le dispositif mémoire 100, les sources S des transistors T sont, par exemple toutes mises au même potentiel, par exemple à un potentiel nul.

A titre d'exemple, la première borne de chaque élément mémoire M est connectée aux drains D des transistors de sa cellule mémoire 101.

A titre d'exemple, la deuxième borne des éléments mémoires M des cellules mémoire 101 d'une même ligne de bits BL sont connectées entre elles.

Dans un tel dispositif, lorsqu'une cellule mémoire 101 est sélectionnée, par exemple la cellule de la ligne de bits BL_{y} et de la ligne de mots WLₓ, on vient appliquer un premier potentiel, non nul, à la ligne de bits BL_{y} et un deuxième potentiel, non nul, à la ligne de mots WLₓ, de façon à rendre les deux transistors de la cellule mémoire sélectionnée passants.

L'application du premier potentiel à la ligne de bits BL_{y} engendre l'apparition dans l'ensemble des transistors des cellules mémoire de la ligne de bit BL_{y}, d'une forte tension, entre le drain D et la source S des transistors bloqués, qui engendre des courants de fuite au sein de ces transistors.

La figure 2 est un exemple d'un circuit électronique d'un dispositif mémoire 200 comportant plusieurs cellules 101 de type mémoire à changement de phase selon un mode de réalisation.

Plus particulièrement, le dispositif 200 est similaire au dispositif 100 illustré en figure 1 à la différence près que les sources S des transistors sont connectées à des lignes de sources SL (de l'anglais « source lines »).

Dans le mode de réalisation de la figure 2, les deux transistors de chaque cellule mémoire 101 sont connectés à deux lignes de source différentes. Les cellules mémoire d'une même ligne de mots WL sont connectées, via les deux transistors qu'elle comporte, aux deux mêmes lignes de source SL.

A titre d'exemple, la cellule mémoire 101, située à l'intersection entre la ligne de bits BL_{y} et la ligne de mots WLₓ, est connectée, via un premier transistor, à une ligne de sources SL_{x-0,5} et est connectée, via un autre transistor, à une ligne de sources SL_{x+0,5}.

Dans le mode de réalisation de la figure 2, chaque ligne de sources est connectée aux cellules mémoire 101 de deux lignes de mots WL successives. En d'autres termes, les cellules mémoire de deux lignes de mots successives sont connectées à une ligne de sources commune.

A titre d'exemple, la ligne de sources SL_{x+0,5} est connectée à un transistor de chaque cellule mémoire de la ligne de mots WLₓ et à un transistor de chaque cellule mémoire de la ligne de mots WLₓ₊₁.

Dans un tel dispositif et similairement à ce qui a été décrit en relation avec la figure 1, lorsqu'une cellule mémoire 101 est sélectionnée, par exemple la cellule de la ligne de bit BL_{y} et de la ligne de mots WLₓ, on vient appliquer un premier potentiel à la ligne de bits BL_{y} et un deuxième potentiel à la ligne de mots WLₓ, de façon à rendre les deux transistors de la cellule mémoire sélectionnée passants.

Dans un tel dispositif, et à la différence de ce qui a été décrit en relation avec la figure 1, on prévoit d'appliquer un potentiel nul aux deux lignes de sources connectées à la cellule mémoire sélectionnée et un troisième potentiel, non nul, à l'ensemble des autres lignes de sources SL.

Ainsi, si la cellule de la ligne de bit BL_{y} et de la ligne de mots WLₓ est sélectionnée, on prévoit d'appliquer un potentiel nul aux lignes de sources SL_{x-0,5} et SL_{x+0,5} et le troisième potentiel à l'ensemble des autres lignes de sources. L'application d'un troisième potentiel ou d'un potentiel nul sélectivement sur les lignes de sources permet de diminuer la tension aux bornes de certains des transistors non sélectionnés et ainsi diminuer les courants de fuite au sein de ces transistors.

A titre d'exemple, pour sélectionner la cellule mémoire de la ligne de bits BL_{y} et de la ligne de mots WLₓ, on applique, à la ligne de bits BL_{y}, un potentiel d'environ 2,85 V et à la ligne de mots WLₓ un potentiel d'environ 1,5 V alors que les autres lignes de bits et lignes de mots ont un potentiel de 0 V. Dans cet exemple, on applique en outre aux lignes de sources SL_{x-0,5} et SL_{x+0,5} un potentiel nul alors que les autres lignes de sources ont un potentiel de 1 V.

Ainsi, le long de la ligne de bits Bl_{y} sélectionnée, les deux transistors de la cellule mémoire de la ligne de mots WLₓ sont rendus passant, les transistors, des cellules mémoire adjacentes à la cellule mémoire sélectionnée, connectés aux lignes de source SL_{x-0,5} et SL_{y+0,5}, sont bloqués et ont entre la source S et le drain D, une tension de 2,85 V et les autres transistors sont bloqués et ont entre la source S et le drain D, une tension de 1,85 V.

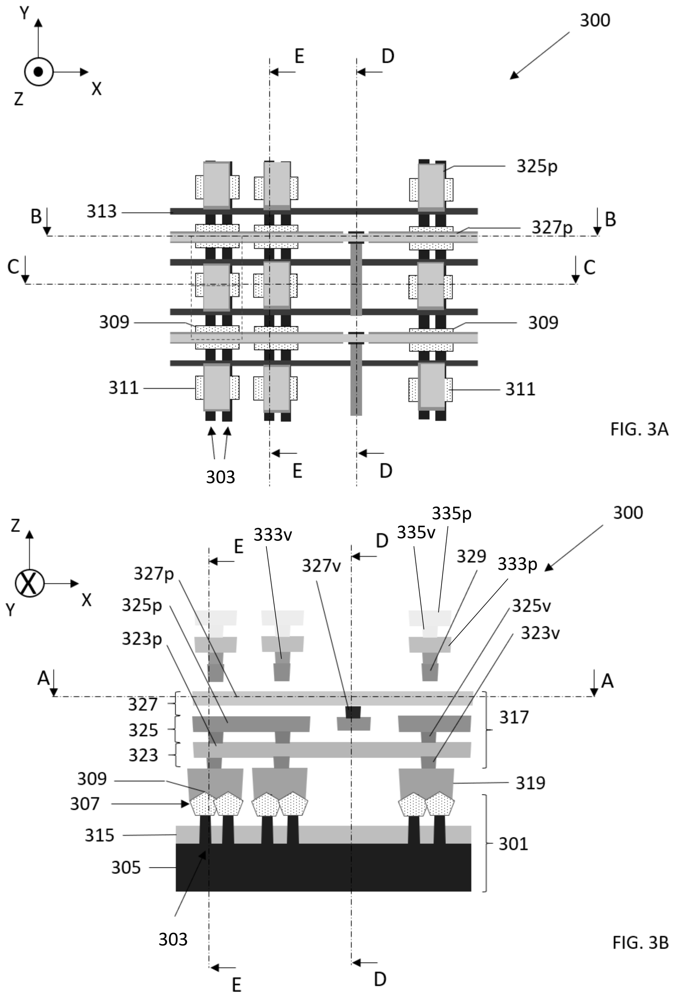

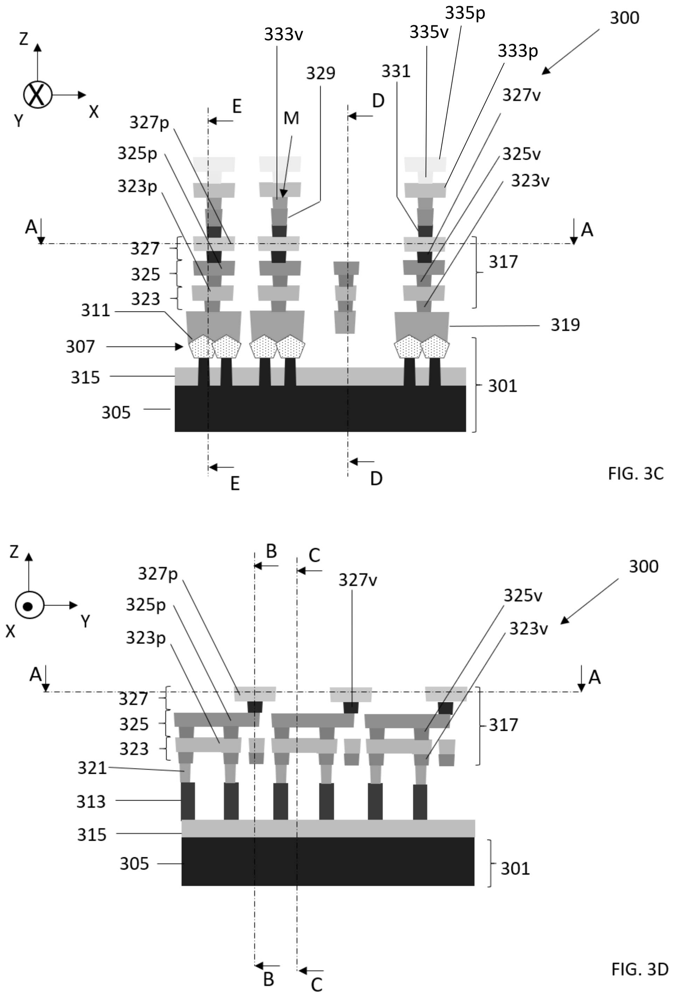

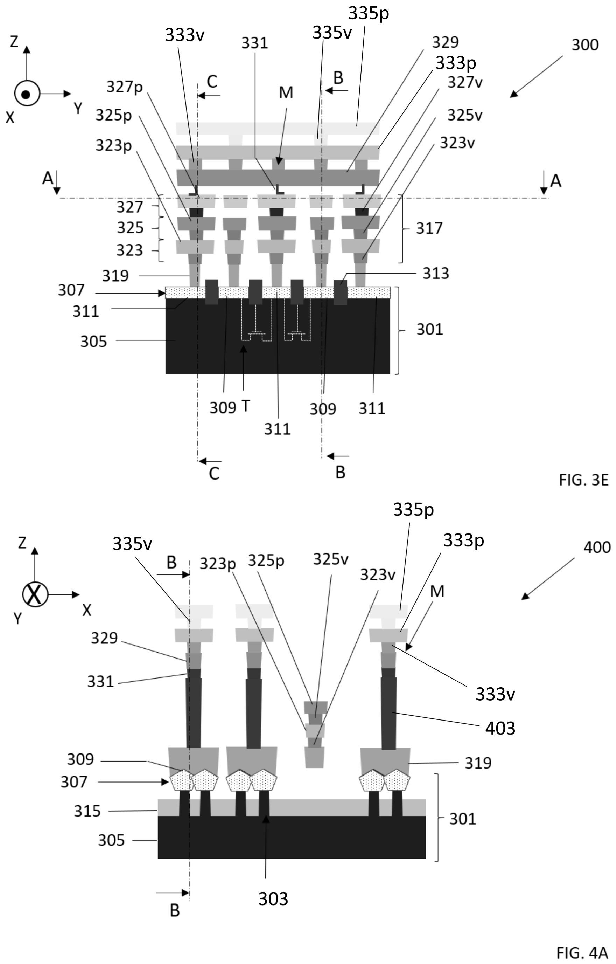

La figure 3A, la figure 3B, la figure 3C, la figure 3D et la figure 3E sont des vues, partielles et schématiques, d'un exemple 300 du dispositif mémoire de la figure 2.

La figure 3A est une vue en coupe selon le plan de coupe horizontal AA des figures 3B, 3C, 3D et 3E. La figure 3B est une vue en coupe selon le plan de coupe BB des figures 3A, 3D et 3E. La figure 3C est une vue en coupe selon le plan de coupe CC des figures 3A, 3D et 3E. La figure 3D est une vue de coupe selon le plan de coupe DD des figures 3A, 3B et 3C. La figure 3E est une vue en coupe selon le plan de coupe EE des figures 3A, 3B et 3C.

Le dispositif 300 est représenté dans un repère direct en trois dimensions XYZ, la figure 3A correspondant à une vue dans un plan XY du repère, les figures 3B et 3C correspondant chacune à une vue dans un plan XZ du repère et les figures 3D et 3E correspondant chacune à une vue dans un plan YZ du repère.

Le dispositif 300 comprend un substrat semiconducteur 301. A titre d'exemple, le substrat 301 est en silicium ou à base de silicium.

Le substrat 301 comprend, par exemple, une couche semiconductrice 305 formée dans une partie inférieure du substrat 301. En outre, le substrat 301 comporte des ailettes 303 formées dans la couche 305, à partir de la face supérieure de la couche 305. A titre d'exemple, les ailettes 303 s'étendent, en vue de dessus, dans une première direction, par exemple dans la direction de l'axe Y.

A titre d'exemple, les ailettes 303 s'étendent dans la direction du plan de la figure 3E. Les ailettes ont, par exemple en vue en coupe, une forme trapézoïdale dont la face inférieure n'est pas orthogonale aux faces latérales. Les ailettes 303 sont par exemple formées par paire dans le substrat 301.

A titre d'exemple, les ailettes ont une hauteur comprise dans la plage allant de 20 nm à 400 nm, par exemple une hauteur de l'ordre de 150 nm. A titre d'exemple, les ailettes ont une largeur comprise dans la plage allant de 2 nm à 30 nm, par exemple une largeur comprise dans la plage allant de 5 nm à 15 nm, par exemple une largeur comprise dans la plage allant de 7 nm à 8 nm. A titre d'exemple, les ailettes d'une même paire sont espacées de 20 nm à 25 nm, par exemple d'environ 22 nm, de sorte que le pas entre deux ailettes de la même paire soit d'environ 30 nm. Les ailettes de deux paires distinctes sont par exemple espacées de 60 nm à 65 nm, par exemple d'environ 62 nm de sorte que le pas entre deux ailettes de deux paires distinctes soit d'environ 100 nm.

A titre d'exemple, le substrat 301 comporte, dans la couche 305, une portion, s'étendant dans la direction de l'axe Y, sans paires d'ailettes 303. A titre d'exemple, dans cette portion du substrat 301 sans ailettes 303, la couche 305 a une épaisseur égale à l'épaisseur de la couche 305 à la base des ailettes 303, c'est-à-dire égale à l'épaisseur de la couche 305 lorsqu'elle ne comprend pas la hauteur des ailettes 303. A titre d'exemple, une telle portion est présente toutes les 100 à 128 paires d'ailettes.

Le substrat 301 comprend par exemple une couche semiconductrice 307. La couche 307 repose par exemple sur la couche 305, et est par exemple en contact avec celle-ci. La couche 307 affleure par exemple une face supérieure du substrat 301. La couche semiconductrice 307 est par exemple une couche formée par épitaxie à partir de la face supérieure de la couche 305. La couche 307 est, par exemple en silicium, par exemple en silicium monocristallin, par exemple dopé in-situ en atomes de phosphore. La couche 307 comprend, par exemple, une pluralité de régions 309 et de régions 311. A titre d'exemple, chaque paire d'ailettes 303 est surmontée, dans sa longueur, c'est-à-dire dans la direction de l'axe Y, d'une succession de région 309 et 311, par exemple disjointes les unes des autres. A titre d'exemple, chaque région 309 ou 311 recouvre les deux ailettes de la paire d'ailettes 303 qu'elle recouvre. A titre d'exemple, une même région 309 ou 311 ne recouvre pas des ailettes de paires différentes.

Dans le dispositif 300, les régions 309 et 311 sont agencées, en vue de dessus, sous forme d'une matrice dont les colonnes correspondent à une succession de régions 309 et 311, formées en vis-à-vis d'une même paire d'ailettes 303 et dont les lignes sont successivement des lignes de régions 309 disjointes et des lignes de régions 311 disjointes.

Chaque région 311 ou 309 s'étend de préférence sur toute la hauteur de la couche 307. Chaque région 311 ou 309 affleure ainsi la face supérieure de la couche 307. Chaque région 311 ou 309 est par exemple en contact, par sa face inférieure, avec la couche 305.

Les régions 309 et 311 sont par exemple dopées d'un type de conductivité, par exemple du type N. A titre d'exemple, les régions 309 et 311 comportent des atomes de phosphore.

A titre d'exemple, les régions 309 et 311 sont séparées deux à deux par une région de grille 313.

Les régions de grille 313 s'étendent, par exemple dans une deuxième direction, par exemple orthogonale à la première direction, par exemple la direction de l'axe X. A titre d'exemple, les grilles 313 s'étendent dans la direction du plan de coupe de la figure 3B. Les grilles 313 sont par exemple en métal, par exemple en nitrure de titane, en nitrure de tantale, en tungstène, ou en une succession de plusieurs couches en l'un et/ou l'autre de ces matériaux.

Le dispositif 300 comprend une pluralité de transistors T formés dans et sur le substrat 301.

Les transistors T sont des transistors à effet de champ à ailettes (FinFET de l'anglais "Fin Field-Effect Transistor").

Dans l'exemple des figures 3A à 3E, chaque transistor T est défini par une grille 313, une région 311 et une région 309. Dans cet exemple, la région 309 constitue une région de source du transistor, la région 311 constitue une région de drain D du transistor et la grille 313 constitue une région de grille du transistor. Comme cela a été décrit en relation avec la figure 2, et comme représenté dans le plan de coupe de la figure 3E, un transistor T a son drain D en commun avec l'un de ses deux transistors voisins et sa source S commune avec l'autre de ses deux transistors voisins.

Chaque transistor T est compris dans une cellule mémoire élémentaire 101 et une cellule mémoire 101 comporte deux transistors. Chaque cellule mémoire comporte en outre un élément mémoire M, formé de préférence au moins partiellement en regard desdits transistors, par exemple en regard de la région 311 de drain D commune auxdits transistors. Les régions 309, à la différence des régions 311, ne sont par exemple pas surmontées d'éléments mémoires M. A titre d'exemple, au sein de chaque cellule mémoire, les transistors sont des transistors de sélection de l'élément mémoire M.

A titre d'exemple, le dispositif 300 comporte une couche isolante 315 formée sur la face supérieure du substrat 305. A titre d'exemple, la couche 315 est formée entre les ailettes 303 du substrat 301. A titre d'exemple, la couche 315 a une épaisseur inférieure à la hauteur des ailettes 303.

A titre d'exemple, la couche isolante 315 est en un matériau isolant, par exemple en un oxyde, par exemple en oxyde de silicium.

Le substrat 301 est par exemple surmonté d'un empilement d'interconnexion 317. A titre d'exemple, l'empilement d'interconnexion 317 est formé sur la face supérieure de la couche 307 et plus particulièrement sur la face supérieure des régions 309 et 311.

A titre d'exemple, l'empilement d'interconnexion 317 est connecté aux régions 309 et 311 par des vias conducteurs 319. Les vias 319 sont par exemple en contact, par leurs faces inférieures, avec la face supérieure de la couche 307 de sorte que chaque région 309 et 311 soit surmontée par un via 319. A titre d'exemple, l'empilement d'interconnexion 317 est en outre connecté à d'autres vias 321 reliant, dans la portion du substrat 301 sans ailettes 303, l'empilement d'interconnexion 317 aux régions de grilles 313.

A titre d'exemple, les vias 319 et 321 sont en un matériau conducteur, par exemple en tungstène.

L'empilement d'interconnexion 317 est par exemple formé d'une succession de niveaux métalliques comportant des pistes et des vias.

L'empilement d'interconnexion 317 comprend par exemple un premier niveau 323. Le niveau métallique 323 comporte par exemple des pistes 323p et des vias 323v, reliant les pistes 323p aux vias 319. A titre d'exemple, les vias 323v sont en contact, par leurs faces supérieures, avec la face inférieure des pistes 323p et, par leurs faces inférieures, avec la face supérieure des vias 319.

A titre d'exemple, dans le plan de coupe de la figure 3B, les pistes 323p sont continues en vis-à-vis de chaque ligne de régions 309, c'est-à-dire qu'une ligne de régions 309 est surmontée par une unique piste 323p. Dans le plan de coupe de la figure 3C, les pistes 323p sont par exemple discontinues en vis-à-vis de chacune des lignes de régions 311, chaque région 311 étant surmontée par une piste 323p disjointe des pistes 323p surmontant les régions 311 voisines.

A titre d'exemple, dans le plan de coupe de la figure 3E, en vis-à-vis de chaque paire d'ailettes 303, une piste 323p est formée en vis-à-vis de chacune des régions 309 et 311. Dans cette direction, les pistes 323p sont disjointes. A titre d'exemple, en vis-à-vis de la portion du substrat sans ailettes 303, dans le plan de coupe de la figure 3D, les pistes 323p relient deux à deux des vias 321. A titre d'exemple, une même piste 323p relie, dans la direction de l'axe Y, dans la portion du substrat 301 sans ailettes 303, les grilles 313 d'une même cellule mémoire 101, c'est-à-dire les grilles 313 séparées, en vue de dessus, par les régions 311.

A titre d'exemple, des vias 323v connectent chaque vias 319 et 321 aux pistes 323p formées en vis-à-vis de ces vias.

L'empilement d'interconnexion 317 comprend par exemple un deuxième niveau 325 formé sur le niveau 323 et par exemple en contact avec le niveau métallique 323. Le niveau métallique 325 comporte par exemple des pistes 325p et des vias 325v, reliant les pistes 325p au niveau métallique 323. A titre d'exemple, les vias 325v sont en contact, par leurs faces supérieures, avec la face inférieure des pistes 325p et, par leurs faces inférieures, avec la face supérieure des pistes 323p.

A titre d'exemple, dans le plan de coupe de la figure 3B, les pistes 325p sont continues en vis-à-vis de chaque ligne de régions 309 en s'interrompant à l'aplomb de chacune des portions de substrat 301 ne comportant pas d'ailettes 303. Dans le plan de coupe de la figure 3C, les pistes 325p sont par exemple discontinues en vis-à-vis de chacune des lignes de régions 311, chaque région 311 étant surmontée par une piste 325p disjointe des pistes 325p surmontant les régions 311 voisines.

A titre d'exemple, dans le plan de coupe de la figure 3E, une piste 325p est formée en vis-à-vis de chacune des pistes 323p. Les pistes 323p et 325p ont, dans ce plan de coupe, le même motif. A titre d'exemple, en vis-à-vis de la portion du substrat sans ailettes 303, dans le plan de coupe de la figure 3D, les pistes 325p relient deux à deux des vias 321. A titre d'exemple, une même piste 325p relie, dans la direction de l'axe Y, dans la portion du substrat 301 sans ailettes 303, via les pistes 323p, les grilles 313 d'une même cellule mémoire 101.

A titre d'exemple, des vias 325v sont formées en vis-à-vis de chacun des vias 323v.

L'empilement d'interconnexion 317 comprend par exemple un troisième niveau 327 formé sur le niveau 325 et par exemple en contact avec le niveau métallique 325. Le niveau métallique 327 comporte par exemple des pistes 327p et des vias 327v, reliant les pistes 327p au niveau métallique 325. A titre d'exemple, les vias 327v sont en contact, par leurs faces supérieures, avec la face inférieure des pistes 327p et, par leurs faces inférieures, avec la face supérieure des pistes 325p.

A titre d'exemple, dans le plan de coupe de la figure 3B, les pistes 327p sont continues en vis-à-vis de chaque ligne de régions 309 sans s'interrompre. A titre d'exemple, dans ce plan de coupe, les pistes 327p sont connectées, par un via 327v, aux pistes 325p formées en vis-à-vis de la portion du substrat 201 sans ailettes 303. Dans le plan de coupe de la figure 3C, les pistes 327p sont par exemple discontinues en vis-à-vis de chacune des lignes de régions 311, chaque région 311 étant surmontée par une piste 327p disjointe des pistes 327p surmontant les régions 311 voisines. Dans ce plan de coupe, les pistes 327p sont connectées aux pistes 325p par des vias 327v formés en vis-à-vis de chacun des vias 325v.

A titre d'exemple, dans le plan de coupe de la figure 3E, une piste 327p est formée en vis-à-vis de chacune des pistes 323p. Les pistes 323p et 327p ont, dans ce plan de coupe, le même motif. Dans ce plan de coupe, des vias 327v reliant les pistes 325p aux pistes 327p sont formés en vis-à-vis de chacun des vias 325v. A titre d'exemple, en vis-à-vis de la portion du substrat sans ailettes 303, dans le plan de coupe de la figure 3D, les pistes 325p sont connectées à des pistes 327p, chaque piste 327p étant formée sur une extrémité d'une piste 325p. A titre d'exemple, chaque piste 327p est, en vue de dessus, formée entre deux grilles de deux cellules mémoire 101 voisines. Dans ce plan de coupe, les pistes 327p et 325p sont connectées par un via 327v.

A titre d'exemple, l'empilement d'interconnexion 317 a une épaisseur comprise entre 200 nm et 800 nm, par exemple comprise entre 250 nm et 600 nm, par exemple de l'ordre de 350 nm.

Les vias et pistes conductrices des niveaux métalliques 323, 325 et 327 sont par exemple en un matériau métallique, par exemple en cuivre.

A titre d'exemple, les vias et pistes conductrices sont entourées de couches isolantes (non représentées), par exemple en un matériau isolant.

Dans cet exemple, l'empilement d'interconnexion 317 est formé entre le substrat 301 et les éléments mémoires M.

Les éléments mémoires M sont par exemple organisés, en vue de dessus, selon une matrice de lignes et de colonnes. On parle respectivement de lignes de mots (word lines) s'étendant dans la deuxième direction, par exemple dans la direction de l'axe X et de lignes de bits (bit lines), s'étendant dans la première direction, c'est à dire la direction de l'axe Y. A titre d'exemple, chaque élément mémoire M est situé à l'intersection d'une ligne de bits et d'une ligne de mots.

A titre d'exemple, les éléments mémoires M illustrés en figure 3C sont des éléments mémoires M d'une même ligne de mots WL alors que les éléments mémoires M illustrés en figure 3E sont des éléments mémoires d'une même ligne de bits BL. En figure 3C, seulement trois lignes de mots sont représentées et en figure 3E seulement trois lignes de bits sont représentées. Toutefois, en pratique, un circuit mémoire peut comprendre un nombre de lignes de bits et de lignes de mots différent, par exemple supérieur à trois.

Les éléments mémoires M sont, dans le mode de réalisation des figures 3A à 3E, formés sur la face supérieure de l'empilement 317.

A titre d'exemple, les éléments mémoires M sont des éléments mémoires M à changement de phase. A titre d'exemple, chaque élément M comprend une couche 329 en un matériau à changement de phase, par exemple un matériau chalcogènure, par exemple un alliage de germanium, antimoine et tellure (GeSbTe) dit GST. La couche 329 a, par exemple, une épaisseur comprise entre 30 nm et 100 nm, par exemple, de l'ordre de 50 nm. Les éléments mémoires M d'une même ligne de bits comprennent par exemple une couche 329 commune. Ainsi, le dispositif 300 comprend par exemple autant de couches 329 que de lignes de bits. Chaque couche 329 s'étend ainsi dans la direction des lignes de bits, c'est-à-dire dans la direction de l'axe Y.

Dans chaque élément mémoire M, le matériau à changement de phase est, par exemple, contrôlé par un élément résistif métallique chauffant 331 situé sous le matériau à changement de phase. L'élément 331 est par exemple en contact, par sa face supérieure, avec la face inférieure de la couche 329. A titre d'exemple, l'élément 331 est en contact, par sa face inférieure, avec la face supérieure de l'empilement d'interconnexion 317 et plus particulièrement, avec la face supérieure de la piste 327p. L'élément 331 est par exemple entouré latéralement d'une couche en un isolant thermique, non représentée. Par exemple, chaque élément 331 a une forme de "L" dans le plan de coupe de la figure 3E. A titre d'exemple, chaque élément possède une partie horizontale formée dans une partie inférieure de l'élément 331. La partie horizontale de l'élément 331 est par exemple en contact avec l'empilement d'interconnexion 317. A titre d'exemple, chaque élément 331 possède une partie verticale formée dans une partie supérieure de l'élément 331 et plus particulièrement sur et en contact avec la partie horizontale de l'élément 331. A titre d'exemple, la partie verticale de l'élément 331 est en contact avec la couche 329. A titre d'exemple, l'élément chauffant 331 a, par exemple, une hauteur comprise entre 30 nm et 100 nm, par exemple de l'ordre de 60 nm. L'élément chauffant 331 est par exemple en un matériau conducteur, par exemple en nitrure de silicium et titane (TiSiN).

La couche 329 est, par exemple surmontée par un ou plusieurs niveaux métalliques. Dans le présent mode de réalisation la couche 329 est surmontée de deux niveaux métalliques 333 et 335. Le niveau métallique 333 est par exemple formé sur la face supérieure de la couche 329 et est par exemple en contact avec celle-ci. A titre d'exemple, le niveau métallique 335 est formé sur la face supérieure du niveau métallique 333 et est par exemple en contact avec celui-ci. A titre d'exemple les niveaux 333 et 335 comportent chacun des pistes et des vias.

A titre d'exemple, le niveau 333 comporte des pistes 333p s'étendant, en vue de dessus, le long de la couche 329. A titre d'exemple, les pistes 333p s'étendent dans la direction de l'axe Y seulement en vis-à-vis de la couche 329. A titre d'exemple, les pistes 333p sont connectées à la couche 329 par l'intermédiaire de vias 333v formés en vis-à-vis des éléments 331. A titre d'exemple, dans chaque élément mémoire M, le niveau 333 et l'élément 331 forment respectivement une électrode supérieure et une électrode inférieure de l'élément mémoire M, et plus précisément des électrodes de l'élément résistif à résistance variable formé par la couche 329 en le matériau à changement de phase. A titre d'exemple, les éléments mémoires M d'une même ligne de bits sont surmontés d'un même niveau 333. En d'autres termes, les électrodes supérieures 333 des éléments mémoires M d'une même ligne de bits sont interconnectées.

A titre d'exemple, le niveau 335 comporte des pistes 335p s'étendant, en vue de dessus, le long des pistes 335p. A titre d'exemple, les pistes 333p et 335p ont, en vue de dessus, la même géométrie. A titre d'exemple, les pistes 333p et 335p sont connectées par l'intermédiaire de vias 335v.

Ainsi, dans le mode de réalisation des figures 3A à 3E, chaque élément chauffant 331 est relié, par sa face inférieure, avec une région 311 de la couche 307 et ce par l'intermédiaire des niveaux 323, 325 et 327.

De plus, dans le mode de réalisation des figures 3A à3E, la portion du substrat 301 sans ailettes 303 correspond à une zone de reprise de contact des lignes de mots WL. Dans cette portion, les deux grilles 313 d'une même cellule mémoire 201 sont connectées à une piste 327p du niveau métallique 327. A titre d'exemple, la piste susmentionnée est commune à l'ensemble des cellules d'une même ligne de mots.

En outre, dans le dispositif 300, les régions 309 d'une même ligne s'étendant dans la direction de l'axe X sont toutes connectées entre elles par l'intermédiaire du niveau métallique 323 correspondant à la ligne de source. A titre d'exemple, dans ce mode de réalisation, les lignes de sources sont, en vue de dessus, parallèles aux lignes de mots.

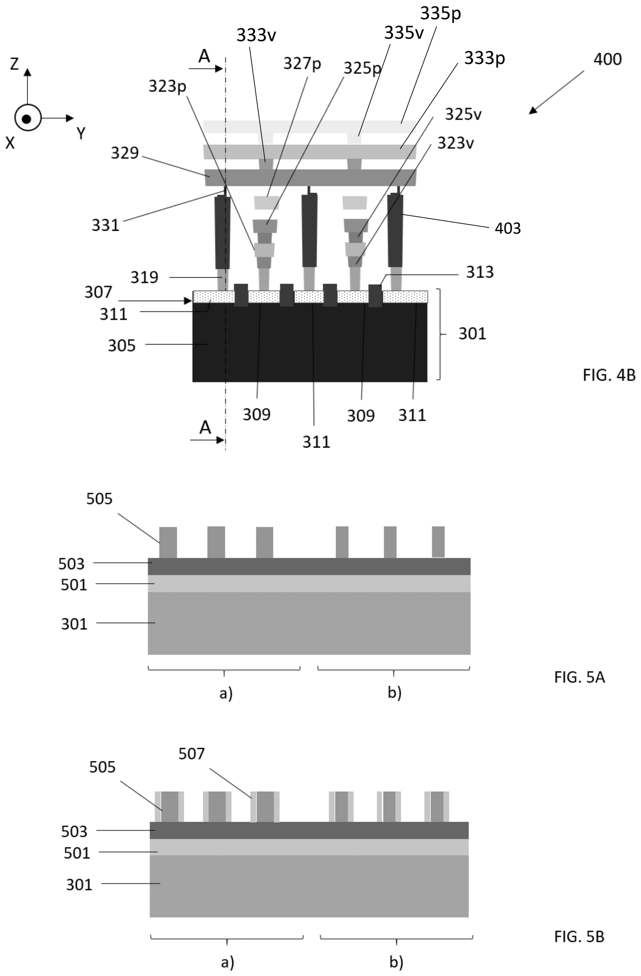

La figure 4A et la figure 4B sont des vues, partielles et schématiques, d'un autre exemple 401 du dispositif mémoire de la figure 2, la figure 4A étant une vue selon le même plan de coupe que la vue de la figure 3C et la figure 4B étant une vue selon le même plan de coupe que la vue de la figure 3E.

Le dispositif 401 est par exemple identique au dispositif 301 illustré en figures 3A à 3E, à la différence près que, dans le dispositif 401, la connexion entre l'élément 331 et les vias 319 est effectuée par un unique via conducteur 403 et non par l'intermédiaire d'une succession de pistes et vias conducteurs.

Ainsi, dans le mode de réalisation des figures 4A et 4B, chaque élément mémoire M est connecté électriquement au transistor de sélection T auquel il est associé par l'intermédiaire du via conducteur 403 traversant tous les niveaux de l'empilement d'interconnexion 317. A titre d'exemple, le via 403 traverse en outre l'ensemble des couches isolantes de l'empilement d'interconnexion 317 et non représentées en figures 4A et 4B.

A titre d'exemple, le via 403, associé à chaque élément mémoire M, est en contact, par sa face supérieure, avec la face inférieure de l'élément résistif chauffant 331 de l'élément mémoire M. Chaque via 403 est par exemple en contact, par sa face inférieure, avec un via conducteur 319, lui-même en contact avec la face supérieure de la région 311 du transistor T associé à l'élément mémoire M. Autrement dit, au sein d'une cellule mémoire 101, le via 403 relie électriquement l'élément chauffant 331 à la région 311 sous-jacente.

Le via conducteur 403 est par exemple en un matériau métallique. Le via conducteur 403 est par exemple en tungstène. En variante, le via conducteur est en cobalt ou en cuivre. Le via conducteur 403 a, par exemple, une largeur, prise dans le plan de la figure 4A et dans le plan de la figure 4B, comprise entre 20 nm et 100 nm, par exemple de l'ordre de 40 nm.

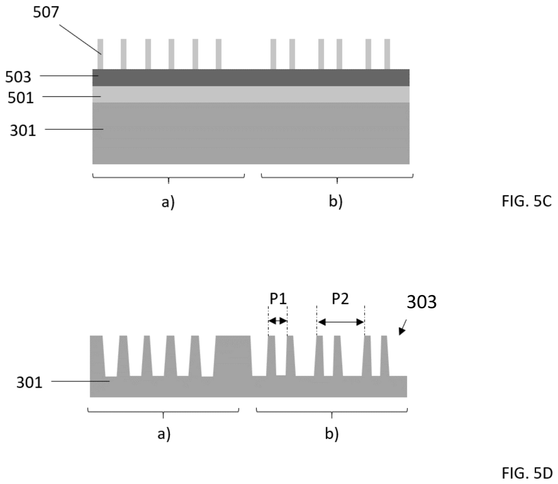

La figure 5A, la figure 5B, la figure 5C et la figure 5D sont des vues, partielles et schématique, illustrant des étapes d'un exemple de procédé de fabrication des dispositifs mémoire illustrés en figures 3A à 3E et en figures 4A et 4B.

Plus particulièrement, les figures 5A à 5D sont des vues illustrant un procédé de fabrication de paires d'ailettes des transistors des dispositifs mémoires décrits ci-avant.

Sur les figures 5A à 5D, sont représentées deux régions a) et b), la région a) correspondant à un procédé de fabrication d'ailettes standards, dont les ailettes sont espacées régulièrement, et la région b) correspondant à un procédé de fabrication de paires d'ailettes au sein d'un dispositif mémoire. Par ailettes espacées régulièrement, on entend des ailettes qui ont toutes le même espacement.

On comprendra qu'en pratique, bien que les deux régions soient représentées au sein d'une seule et même structure, la région b) peut être fabriquée indépendamment de la région a).

La figure 5A illustre, par une vue en coupe partielle et schématique, une structure de départ comportant le substrat semiconducteur 301 surmonté d'une première couche isolante 501, d'une deuxième couche isolante 503 et d'une couche en silicium amorphe 505.

Dans la structure de la figure 5A, la couche 501 est en contact, par sa face inférieure, avec la face supérieure du substrat. De plus, dans la structure illustrée en figure 5A, la couche 503 est en contact, par sa face inférieure, avec la face supérieure de la couche 501. En outre, dans la structure illustrée en figure 5A, la couche 505 est en contact, par sa face inférieure, avec la face supérieure de la couche 503.

A titre d'exemple, la couche 501 est en un oxyde, par exemple en oxyde de silicium. A titre d'exemple, la couche 503 est en un nitrure, par exemple en nitrure de silicium.

La couche 505 comporte à la surface de la couche 503, plusieurs motifs ou plots.

Dans la région a) de la figure 5A, les plots de la couche 503 ont une largeur d'environ 30 nm et sont tous espacés d'environ 50 nm.

Dans la région b) de la figure 5A, les plots de la couche 503 ont une largeur d'environ 20 nm et sont tous espacés d'environ 60 nm.

Dans les régions a) et b) les plots de la couche 503 ont un pas de répétition d'environ 100 nm.

La figure 5B illustre une structure obtenue à l'issue d'une étape de formation d'espaceurs sur la face supérieure de la structure illustrée en figure 5A.

Plus particulièrement, lors de cette étape, on vient former, sur les flancs des plots de la couche 505, des espaceurs 507.

Les espaceurs 507 sont par exemple formés sur l'ensemble des régions a) et b).

Les espaceurs 507 sont par exemple en le même matériau que la couche 501. A titre d'exemple, les espaceurs 507 sont en oxyde de silicium.

La figure 5C illustre une structure obtenue à l'issue d'une étape de retrait des plots de la couche 505 et de sorte que seuls les espaceurs 507 ne subsistent sur la face supérieure de la couche 503.

La figure 5D illustre une structure obtenue à l'issue d'une étape de gravure du substrat par transfert du motif formé par les espaceurs 507. Lors de cette étape, le substrat est gravé en formant les ailettes. A l'issue de cette étape, dans la région a), les ailettes ont un pas de répétition d'environ 40 nm. A l'issue de cette étape, dans la région b), les ailettes sont formées par deux, le pas de répétition P1 entre deux ailettes proches l'une de l'autre étant de l'ordre de 30 nm et le pas de répétition P2 entre deux paires d'ailettes étant de l'ordre de 100 nm.

Le pas de répétition P1 est alors suffisamment faible pour que les croissances par épitaxie à partir des ailettes d'une même paire d'ailettes se rejoignent en formant les régions 309 et 311. De plus, le pas de répétition P2 est suffisamment élevé pour que les croissances par épitaxie à partir des ailettes de deux paires d'ailettes distinctes et voisines ne se rejoignent pas, évitant ainsi les courts-circuits entre les éléments mémoires d'une même ligne de bits.

De préférence, la région a) et la région b) correspondent à deux parties d'un même dispositif électronique. A titre d'exemple, la région a) correspond à une partie du dispositif électronique dans laquelle les circuits logiques sont formés et la région b) correspond à une partie du dispositif électronique dans laquelle les circuits mémoires sont formés.

Dans la région a), les ailettes 303 sont régulièrement réparties sur la surface de la région, c'est-à-dire que la distance centre à centre entre deux ailettes voisines, aussi appelée pas de répétition des ailettes, est sensiblement constante sur toute la surface de la région.

Dans la région b), les ailettes 303 sont regroupées par paires. Les ailettes 303 d'une même paire sont plus rapprochées que des ailettes 303 de deux paires voisines. Le pas de répétition P1 (distance centre à centre entre deux ailettes d'une même paire) est sensiblement constant sur toute la surface de la région b), et le pas de répétition P2 (distance centre à centre entre deux paires d'ailettes voisines) est sensiblement constant sur toute la surface de la région b).

Bien que l'on ait décrit un exemple dans lequel, dans la région b), le pas de répétition P1 est de l'ordre de 30 nm et le pas de répétition P2 est de l'ordre de 100 nm, et dans lequel, dans la région a), le pas de répétition des ailettes est d'environ 40 nm, les modes de réalisation ne se limitent pas à cet exemple particulier.

De préférence, la distance entre deux ailettes d'une même paire de la région b) est inférieure à la distance entre deux ailettes voisines de la région a). De préférence, la distance entre deux ailettes de deux paires voisines dans la région b) est supérieure à la distance entre deux ailettes voisines de la région a).

Un avantage du présent mode de réalisation est que la formation des transistors sur des paires d'ailettes permet de réduire la dimension des dispositifs électroniques.

Un autre avantage du présent mode de réalisation est que la formation des transistors sur des paires d'ailettes permet d'augmenter le courant délivré par les transistors.

Encore un autre avantage du présent mode de réalisation est que la connexion des lignes de sources parallèlement aux lignes de mots permet de réduire l'encombrement au sein des dispositifs et diminuer les courants de fuite au sein de certains transistors bloqués.

Divers modes de réalisation et variantes ont été décrits. La personne du métier comprendra que certaines caractéristiques de ces divers modes de réalisation et variantes pourraient être combinées, et d'autres variantes apparaîtront à la personne du métier. En particulier, on notera que dans tous les exemples décrits ci-dessus, les nœuds de conduction de drain D et de source S des transistors T peuvent être inversés. La personne du métier saura alors adapter les potentiels de commande du circuit mémoire pour obtenir le fonctionnement recherché.

Enfin, la mise en oeuvre pratique des modes de réalisation et variantes décrits est à la portée de la personne du métier à partir des indications fonctionnelles données ci-dessus.

## Revendications

1. Dispositif mémoire (200 ; 300 ; 400) comportant une pluralité de cellules mémoire (101) organisées en une matrice de lignes mots (WL) et lignes de bits (BL), chaque cellule mémoire (101) comportant un élément mémoire (M) en un matériau (329) à changement de phase et deux transistors (T) à effet de champ à ailettes de sélection de l'élément mémoire (M), chaque transistor (T) comprenant des premier (D) et deuxième (S) noeuds de conduction et une grille, l'élément mémoire (M) comportant deux bornes, dans lequel :
- les deux transistors d'une même cellule mémoire (101) sont connectés entre eux par leurs premiers noeuds de conduction (D), lesdits premier noeuds de conduction (D) étant eux même connectés à une première borne de l'élément mémoire (M) ;
- les éléments mémoires (M) d'une même ligne bits (BL) sont tous connectés entre eux par leurs deuxièmes bornes ;
- les deux transistors (T) des cellules mémoire (101) d'une même ligne de mots (WL) sont tous connectés entre eux, par leurs grilles ;
- chaque cellule mémoire (101) est connectée à deux lignes de sources (SL), les deux lignes de sources (SL) étant connectées respectivement aux deux deuxièmes noeuds de conduction (S) des transistors (T) de la cellule mémoire (101), les cellules mémoire (101) d'une même ligne de mots (WL) étant connectées aux mêmes deux lignes de sources (SL) et les cellules mémoire (101) de deux lignes de mots (WL) successives étant connectées à une ligne de sources (SL) commune ; et
- chaque transistor (T) est disposé dans et sur une paire de deux ailettes parallèles et voisines disposées dans un substrat semiconducteur (301).

2. Dispositif mémoire selon la revendication 1, dans lequel les transistors (T) des cellules mémoire d'une même ligne de bits (BL) sont disposés dans et sur la même paire de deux ailettes (A).

3. Dispositif mémoire selon la revendication 1 ou 2, dans lequel les ailettes d'une même paire sont espacées de 20 nm à 25 nm, par exemple d'environ 22 nm.

4. Dispositif mémoire selon l'une quelconque des revendications 1 à 3, dans lequel les paires d'ailettes, sur et dans lesquelles sont disposées les cellules mémoire de deux lignes de bits successives, sont espacées de 60 nm à 65 nm, par exemple d'environ 62 nm.

5. Dispositif mémoire selon l'une quelconque des revendications 1 à 4, dans lequel le matériau (329) à changement de phase est un alliage de germanium, antimoine et tellure.

6. Dispositif mémoire selon l'une quelconque des revendications 1 à 5, dans lequel, au sein de chaque cellule mémoire (101), l'élément mémoire (M) est séparé des transistors (T) par un empilement d'interconnexion (317).

7. Dispositif mémoire selon la revendication 6, dans lequel chaque élément mémoire (M) est connecté aux premiers noeuds de conduction (D) des deux transistors (T) de la même cellule mémoire (M) par l'intermédiaire d'un via conducteur (403) traversant l'empilement d'interconnexion (317).

8. Dispositif mémoire selon l'une quelconque des revendications 1 à 7, dans lequel l'élément mémoire (M) comporte un élément résistif métallique chauffant (331) disposé sous le matériau (329) à changement de phase et contrôlant ce même matériau.

9. Dispositif mémoire selon l'une quelconque des revendications 1 à 8, dans lequel les lignes de sources (SL) sont, en vue de dessus, parallèles aux lignes de mots (WL).

10. Dispositif mémoire selon l'une quelconque des revendications 1 à 9, dans lequel les ailettes d'une même paire sont plus rapprochées que des ailettes (303) de deux paires voisines.

11. Dispositif mémoire selon la revendication 10, dans lequel les ailettes sont disposées dans une première région (b) du substrat semiconducteur,
le dispositif comprenant en outre, d'autres ailettes, espacées régulièrement, disposées dans une deuxième région (a) du substrat semiconducteur.

12. Procédé de fabrication d'un dispositif comportant une pluralité de cellules mémoire (101) organisées en une matrice de lignes mots (WL) et lignes de bits (BL), chaque cellules mémoire (101) comportant un élément mémoire (M) en un matériau (329) à changement de phase et deux transistors (T) à effet de champ à ailettes de sélection de l'élément mémoire (M), chaque transistor (T) comprenant des premier (D) et deuxième(S) noeuds de conduction et une grille, l'élément mémoire (M) comportant deux bornes (B1, B2), dans lequel :
- les deux transistors d'une même cellule mémoire (101) sont connectés entre eux par leurs premiers noeuds de conduction (D), lesdits premiers noeuds de conduction (D) étant eux même connectés à une première borne (B1) de l'élément mémoire (M) ;
- les éléments mémoires (M) d'une même ligne bits (BL) sont tous connectés entre eux par leurs deuxièmes bornes ;
- les deux transistors (T) des cellules mémoire (101) d'une même ligne de mots (WL) sont tous connectés entre eux, par leurs grilles ;
- chaque cellule mémoire (101) est connectée à deux lignes de sources (SL), les lignes de sources (SL) étant connectées respectivement aux deux deuxièmes noeuds de conduction (S) des transistors (T) de la cellule mémoire (101), les cellules mémoire (101) d'une même ligne de mots (WL) étant connectées aux mêmes deux lignes de sources (SL) et les cellules mémoire (101) de deux lignes de mots (WL) successives étant connectées à une ligne de sources (SL) commune,
le procédé comportant les étapes de :
- formation d'ailettes dans un substrat semiconducteur, les ailettes étant formées par paires ;
- formation d'une couche semiconductrice (307) par épitaxie ; et
- dopage de la couche semiconductrice (307) de façon à former des régions (309, 311) parmi lesquelles des premières régions (309) correspondent à des régions de source et des deuxième régions (311) correspondent à des régions de drain, une région de drain étant commune aux deux transistors d'une même cellule mémoire et une région de source étant commune à deux transistors de deux cellules mémoire (101) voisines.

13. Procédé selon la revendication 12, dans lequel les ailettes d'une même paire sont plus rapprochées que des ailettes (303) de deux paires voisines.

14. Procédé selon la revendication 13, dans lequel la formation des ailettes est réalisée dans une première région (b) du substrat semiconducteur,
le procédé comprenant en outre, pendant l'étape de formation des ailettes, la formation d'autres ailettes, espacées régulièrement, dans une deuxième région (a) du substrat semiconducteur.

15. Procédé d'utilisation du dispositif selon l'une quelconque des revendications 1 à 11, comprenant pour la sélection d'une cellule mémoire (101) d'une première ligne de mots (WL) et d'une première ligne de bits (BL) :
- application d'un premier potentiel non nul sur la première ligne de bits (BL) et d'un potentiel nul sur les autres lignes de bits (BL) ;
- application d'un deuxième potentiel non nul sur la première ligne de mots (WL) et d'un potentiel nul sur les autres lignes de mots (WL) ;
- application d'un potentiel nul aux deux lignes de sources (SL) connectées aux cellules mémoire de la première ligne de mots et un troisième potentiel non nul aux autres lignes de sources (SL).
